# EUROPEAN PATENT APPLICATION

(11) **EP 2 738 446 A1**
(43) Date of publication of application: **04.06.2014**
(21) Application number: 11870481.6
(22) Date of filing: 29.07.2011
(51) Int. Cl.: F21S 2/00, F21V 19/00, H01L 33/54

(54) **LIGHT-EMITTING DEVICE AND ILLUMINATION DEVICE**

(71) Applicant: Toshiba Lighting & Technology Corporation, Yokosuka-shi, Kanagawa 237-8510 (JP)
(72) Inventor: KAWASHIMA, Seiko, 237-8510 Kanagawa (JP); OYAIZU, Tsuyoshi, 237-8510 Kanagawa (JP); TAMAI, Hiroki, 237-8510 Kanagawa (JP); HAYASHIDA, Yumiko, 237-8510 Kanagawa (JP); MATSUDA, Shuhei, 237-8510 Kanagawa (JP); SHIBUSAWA, Soichi, 237-8510 Kanagawa (JP); OGATA, Masahiro, 237-8510 Kanagawa (JP); UEMURA, Kozo, 237-8510 Kanagawa (JP); NISHIMURA, Kiyoshi, 237-8510 Kanagawa (JP)
(74) Representative: Willquist, Sofia Ellinor
(86) International application number: PCT/JP2011/067527
(87) International publication number: WO 2013/018175

(57) **Abstract**

To improve an angular color difference and emit uniform illumination light. According to an embodiment, a light-emitting device in an embodiment includes a light-emitting module (15). The light-emitting module (15) includes a substrate (21), a plurality of light-emitting elements (45) made of semiconductor, and a plurality of sealing members (54). The light-emitting elements (45) are disposed on the substrate (21). The sealing members (54) contain, as a main component, translucent resin mixed with a phosphor. The sealing members (54) are heaped up from the bottom surfaces thereof bonded on the substrate (21) and are each formed to bury a singularity or a plurality of the light-emitting elements (45). A ratio (H/D) of a diameter D of the bottom surfaces to height H of the heaps of the sealing members (54) is set to 0.22 to 1.0.

## Description

### Technical Field

The present invention relates to a light-emitting device including semiconductor light-emitting elements such as LEDs (light-emitting diodes) and a luminaire such as a lighting fixture including the light-emitting device as a light source.

### Background Art

Recently, development of a light source (an LED light source) of a luminaire including a plurality of LEDs has been under way. There is known an LED array usable as the light source of the luminaire of this type. In the LED array, a plurality of first conductive patterns, a plurality of second conductive patterns, a plurality of LED chips, a plurality of bonding wires, and a plurality of transparent resins are provided on a printed board.

The surface of the printed board is covered with a white resist. The first and second conductive patterns are disposed along the longitudinal direction of the printed board. The second conductive patterns are individually adjacent to the plurality of first conductive patterns. The first conductive patterns are larger than the LED chips. The LED chips are respectively die-bonded to the first conductive patterns. The bonding wires connect the LED chips and the second conductive patterns adjacent to the first conductive patterns to which the LED chips are die-bonded. The transparent resins are formed on a substrate by potting. The transparent resin buries and seals one LED chip, the bonding wire connected to the LED chip, and the like.

Unhardened transparent resin dripped on the substrate is formed in a dome-like convex shape right after the dripping. However, the base of the transparent resin relatively easily spreads until the transparent resin is hardened and the height of the transparent resin decreases. Therefore, it is difficult to form the transparent resin in a predetermined shape.

Incidentally, in general, a phosphor is mixed in the transparent resin in order to obtain illumination light of a desired color. For example, if the LED chip emits blue light, to obtain white illumination light, a phosphor excited by the blue light to emit yellowish light is mixed in the transparent resin.

If the transparent resin mixed with the phosphor in this way is not formed in a predetermined shape, it is highly likely that the distance from the LED chip sealed by the resin to sections of the surface of the transparent resin is not equal to or larger than a fixed distance. If the distance is too small, a light emission color of the LED chip tends to be more predominant. Conversely, if the distance is too large, a color emitted from the phosphor tends to be more predominant.

Therefore, when an LED light source is visually recognized, a color difference sometimes occurs depending on an angle of viewing the LED light source (this is referred to as angular color difference).

To improve the angular color difference, a bank surrounding the transparent resin only has to be formed on the printed board to stop the spreading of the unhardened transparent resin with the bank. However, this increases the number of components and complicates a configuration. Therefore, costs increase.

### Citation List

### Patent Literature

Patent Literature 2: JP-A-5-299702

### Summary of Invention

### Technical Problem

It is an object of an embodiment to provide a light-emitting device and a luminaire that can improve an angular color difference and emit uniform illumination light.

### Solution to Problem

A light-emitting device in an embodiment includes a light-emitting module including a substrate, a plurality of light-emitting elements made of semiconductor, and a plurality of sealing members. The light-emitting elements are disposed on the substrate. The sealing members contain, as a main component, translucent resin mixed with a phosphor. The sealing members are heaped up from the bottom surfaces thereof bonded on the substrate and are each formed to bury a singularity or a plurality of the light-emitting elements. A ratio (H/D) of a diameter D of the bottom surfaces to height H of the heaps of the sealing members is set to 0.22 to 1.0.

### Brief Description of the Drawings

[Fig. 1] Fig. 1 is a perspective view showing a lighting fixture according to a first embodiment.
[Fig. 2] Fig. 2 is a sectional view showing the lighting fixture shown in Fig. 1.
[Fig. 3] Fig. 3 is a front view showing a state in which a plurality of light-emitting modules included in a lamp of the lighting fixture shown in Fig. 1 are arranged.
[Fig. 4] Fig. 4 is a front view showing one of the light-emitting modules shown in Fig. 3.
[Fig. 5] Fig. 5 is a front view showing an F5 portion in Fig. 4 in enlargement.
[Fig. 6] Fig. 6 is a front view showing an F6 portion in Fig. 4 in enlargement.
[Fig. 7] Fig. 7 is a sectional view taken along line F7-F7 in Fig. 4.
[Fig. 8] Fig. 8 is a sectional view taken along line F8-F8 in Fig. 4.
[Fig. 9] Fig. 9 is a front view showing the light-emitting module shown in Fig. 4 in a state in which mounted components and sealing members are removed.
[Fig. 10] Fig. 10 is an enlarged view of an F10 portion in Fig. 9.
[Fig. 11] Fig. 11 is an enlarged view showing an F11 portion in Fig. 4 with a part thereof cut out.
[Fig. 12] Fig. 12 is a schematic diagram showing the configuration of the sealing member included in the light-emitting module shown in Fig. 4.

### Description of Embodiments

A light-emitting device according to a first embodiment includes a light-emitting module. The light-emitting module includes a substrate, a plurality of light-emitting elements made of semiconductor disposed on the substrate, and a plurality of sealing members containing, as a main component, translucent resin mixed with a phosphor, heaped up from the bottom surfaces thereof bonded on the substrate, and each formed to bury a singularity or a plurality of the light-emitting elements, a ratio (H/D) of a diameter D of the bottom surfaces to height H of the heaps being set to 0.22 to 1.0.

The light-emitting device in the first embodiment can be used as a light source mounted on, for example, a lighting fixture or a display device.

In the first embodiment, as the substrate, a single-layer or double-layer resin substrate can also be used. Further, in order to suppress a warp of the substrate and improve thermal radiation properties from the substrate, it is preferable to use a substrate having a configuration in which a metal foil of aluminum, iron, copper, or the like is laminated on the rear surface thereof.

In the first embodiment, representative examples of the light-emitting element made of semiconductor include an LED (light-emitting diode) chip. However, a semiconductor laser and the like can also be used. If the LED chip is used as the light-emitting element, a light emission color of the LED chip may be any one of red, green, and blue. LED chips having different light emission colors can also be used in combination.

In the first embodiment, as the resin contained as the main component of the sealing members that bury the light-emitting elements and the like, translucent and thermoplastic synthetic resin, for example, various kinds of epoxy resin or various kinds of silicone resin can be used. In the first embodiment, the number of the light-emitting elements buried by each of the sealing members is not limited to one and may be plural.

In the first embodiment, since the aspect ratio (H/D) of each of the sealing members, which seal the light-emitting element, is specified as explained above, a distance equal to or larger than 1 mm can be secured as a distance from the light-emitting element to positions on the surface of the sealing member. Therefore, it is possible to suppress an angular color difference without requiring a bank for preventing the sealing member from spreading before being hardened.

In a light-emitting device in a second embodiment, in the first embodiment, the sealing member is resin-based silicone resin and the hardness of the sealing member after formation is equal to or higher than 54 and equal to or lower than 94 in Shore hardness.

In the second embodiment, in the first embodiment, further, since the Shore hardness of the resin-based silicone resin forming the sealing member is in a range of (74±20), thixotropy until the hardening of the sealing members is improved. Consequently, the sealing member is suppressed from spreading before being hardened and decreasing in height. A distance equal to or larger than 1 mm can be secured as the distance from the light-emitting element to the positions on the surface of the sealing member. On the other hand, if the Shore hardness of the sealing member is lower than 54, the thixotropy decreases and it is difficult to secure a distance equal to or larger than 1 mm as the distance from the light-emitting element to the positions on the surface of the sealing member. If the Shore hardness of the sealing member exceeds 94, fluidity of the unhardened sealing member is lower than a specified value. Consequently, if the sealing member is formed by, for example, potting, an appropriate amount of the potting is difficult. Therefore, it is more likely that a potting failure is caused.

In a light-emitting device in a third embodiment, in the first embodiment, a wiring pattern is formed on the substrate. The light-emitting element is mounted on a mounting pad formed by a part of the wiring pattern. A wire connecting section adjacent to the mounting pad is formed on the substrate. The light-emitting device includes a wire that connects the mounting pad and the wire connecting section. One end of the wire connected to the light-emitting element is projected in the thickness direction of the light-emitting element to separate from the element. The other end of the wire connected to the wire connecting section is oblique. An intermediate portion of the wire between the one end and the other end is formed to be bent from the one end to be parallel to the light-emitting element. Projection height of the intermediate portion with respect to the light-emitting element is equal to or larger than 75 µm and equal to or smaller than 125 µm.

In the third embodiment, the wire is provided by wire bonding. A thin metallic wire, for example, a thin wire of gold can be suitably used. In the third embodiment, the description that the intermediate portion of the wire is formed to be bent from the one end of the wire to be parallel to the light-emitting element includes the meaning that the intermediate portion is parallel to the light-emitting element. However, actually, in some case, the intermediate portion is not completely parallel to the light-emitting element because of fluctuation in manufacturing. Such a fluctuating form is also included in the scope of the wording "to be parallel". Therefore, in the third embodiment, it is possible to rephrase the description as "the intermediate portion of the wire is substantially parallel to the light-emitting element". Therefore, a form in which the intermediate portion of the wire is obliquely bent from the one end of the wire and provided such that an angle formed by the one end and the intermediate portion is an acute angle is outside the scope of the wording.

Incidentally, the sealing member expands and contracts according to light emission and a stop of the light emission device. Stress is applied to the wire buried in the sealing member because of the expansion and contraction. However, in the third embodiment, the intermediate portion of the wire is formed to be bent from the one end of the wire connected to the light-emitting element to be parallel to the light-emitting element. At the same time, the projection height of the intermediate portion of the wire with respect to the light-emitting element is specified to be equal to or larger than 75 µm and equal to or smaller than 125 µm.

Consequently, the stress is reduced according to a reduction in the influence of the expansion and contraction of the sealing member on the wire. Therefore, it is possible to suppress the wire from being cut in a connecting section of the one end of the wire and the light-emitting element.

In a light-emitting device in a fourth embodiment, in the third embodiment, a protection member made of resin covering the wiring pattern is formed on the substrate. The mounting pad is covered with the sealing member. A groove is formed in at least one part of a peripheral portion of the mounting pad. A filled part of the protection member filled in the groove is bonded to the sealing member.

In the light-emitting device in the fourth embodiment, in the third embodiment, further, adhesiveness of the sealing member made of resin and the mounting pad made of metal covered with the sealing member is inferior to adhesiveness of resins. Consequently, it is likely that the sealing member peels. However, the filled part of the protection member made of resin filled in the groove in the peripheral portion of the mounting pad and the mounting pad are bonded. Therefore, holding performance of the sealing resin is improved and the peeling of the sealing resin can be suppressed.

A light-emitting device in a fifth embodiment further includes, in the first embodiment, a diffusive translucent pipe in which the light-emitting module is housed. If the pipe is made of resin in this embodiment, examples of the resin include polycarbonate resin.

In the fifth embodiment, in the first embodiment, further, it is possible to diffuse, with the pipe, light emitted from the light-emitting module and emit the light to the outside of the pipe as illumination light. Therefore, if the pipe is straight, the light-emitting device in the fifth embodiment can be implemented as a straight tube type lamp, which is a light source. If the pipe is annular, the light-emitting device in the fifth embodiment can be implemented as an annular lamp, which is a light source.

In a light-emitting device in a sixth embodiment, in the fifth embodiment, the translucency of the pipe is equal to or lower than 85% and the disposing pitch of the light-emitting elements is equal to or larger than 5 mm and equal to or smaller than 9 mm.

In the sixth embodiment, since the translucency of the pipe is equal to or lower than 85%, it is possible to make it less easy for the plurality of light-emitting elements from changing to light spots to be reflected on the pipe. If the disposing pitch of the light-emitting elements is smaller than 5 mm, the light-emitting elements are arranged at high density to be a main cause of an increase in costs. If the disposing pitch of the light-emitting elements exceeds 9 mm, the light-emitting elements are arranged at low density and further tend to be reflected on the pipe.

Therefore, in the sixth embodiment, in the fifth embodiment, further, it is possible to suppress, at low costs, the plurality of light-emitting elements from changing to light spots to be reflected on the pipe and flash the pipe at substantially uniform brightness.

A luminaire in a seventh embodiment is a luminaire including a luminaire main body, at least a pair of sockets attached to the luminaire main body, and a straight tube type light-emitting device including a diffusive translucent straight pipe, a light-emitting module formed long in an extending direction of the pipe and housed in the pipe, and caps attached to longitudinal direction both ends of the pipe, the light-emitting device being supported detachably to the sockets. The light-emitting module has a configuration explained below.

The light-emitting module includes a substrate, a plurality of light-emitting elements made of semiconductor disposed on the substrate, and a plurality of sealing members containing, as a main component, translucent resin mixed with a phosphor, heaped up from the bottom surfaces thereof bonded on the substrate, and each formed to bury a singularity or a plurality of the light-emitting elements, a ratio (H/D) of a diameter D of the bottom surfaces to height H of the heaps being set to 0.22 to 1.0.

The seventh embodiment is the luminaire including the light-emitting device as a straight tube type lamp, which is a light source. The light-emitting device includes the light-emitting module described in the first embodiment. Therefore, since a distance equal to or larger than 1 mm is secured as a distance from the light-emitting element to positions on the surface of the sealing member, an effect can be expected that it is possible to provide the luminaire that can improve an angular color difference and emit uniform illumination light.

### First Embodiment

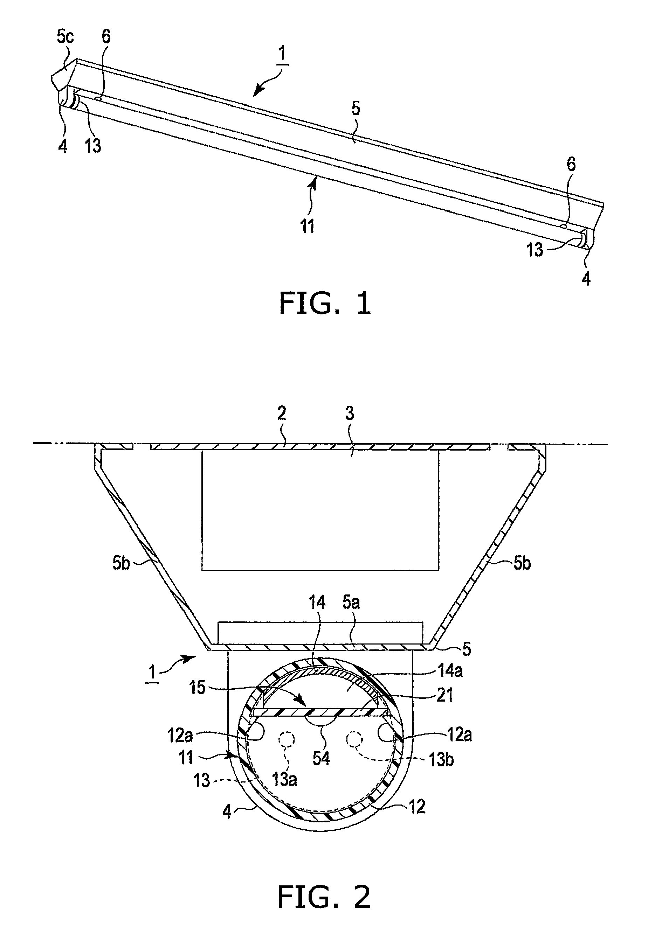

A light-emitting device in a first embodiment and a luminaire, for example, a lighting fixture including the light-emitting device as a light source are explained in detail below with reference to Figs. 1 to 12.

Reference numeral 1 in Figs. 1 and 2 denotes a lighting fixture for one lamp. This lighting fixture 1 includes a fixture main body (a luminaire main body) 2, a lighting circuit 3, a pair of sockets 4, and a reflecting member 5 and includes, as a light-emitting device, for example, a straight tube type lamp 11 forming a light source.

The fixture main body 2 shown in Fig. 2 is made of, for example, a metal plate having an elongated shape. The fixture main body 2 extends in the front back direction of the paper surface on which Fig. 2 is drawn. The fixture main body 2 is fixed to, for example, an indoor ceiling using a not-shown plurality of screws.

The lighting circuit 3 is fixed to an intermediate portion in the longitudinal direction of the fixture main body 2. The lighting circuit 3 is configured to receive a commercial alternating current power supply and generate a direct-current output. The lighting circuit 3 supplies the direct-current output to a below-mentioned lamp 11.

Note that, a power supply terminal block, a plurality of member supporting fittings, a pair of socket supporting members, and the like, all of which are not shown in the figure, are attached to the fixture main body 2. A power supply line of the commercial alternating-current power supply drawn in from the attic is connected to the power supply terminal block. Further, the power supply terminal block is electrically connected to the lighting circuit 3 and below-mentioned sockets 4 through a not-shown intra-fixture wire.

The sockets 4 are coupled to the socket supporting member and respectively disposed at longitudinal direction both ends of the fixture main body 2. Both the sockets 4 are existing sockets matching, for example, caps 13 of a G13 type included in the below-mentioned lamp 11. However, the sockets 4 are not limited to the existing sockets. Sockets of types matching a type of a cap can be used.

The sockets 4 include a not-shown pair of power supply terminals and the like to which below-mentioned terminal pins 13a and 13b are connected. In order to supply electric power to the below-mentioned lamp 11, the intra-fixture wire is connected to only the power supply terminal of the socket 4 on one side. A wire for power supply is not connected to the other socket 4.

The reflecting member 5 includes a bottom plate section 5a, a side plate section 5b, and a pair of end plates 5c (only one of which is shown in Fig. 1) made of, for example, metal and is formed in a trough shape, the upper surface of which is opened.

The bottom plate section 5a is flat. The side plate section 5b is bent obliquely upward from width direction both ends of the bottom plate section 5a. The pair of end plates 5c respectively closes end face openings formed by the bottom plate section 5a and ends in the longitudinal direction of the side plate section 5b. A metal plate forming the bottom plate section 5a and the side plate section 5b is made of a color steel plate, the surface of which assumes a whitish color. Therefore, the surfaces of the bottom plate section 5a and the side plate section 5b are formed as reflection surfaces. Not-shown socket through-holes are respectively opened at longitudinal direction both ends of the bottom plate section 5a.

The reflecting member 5 covers the fixture main body 2 and components attached to the fixture main body 2. This state is retained by detachable decoration screws (see Fig. 1) 6. The decoration screws 6 can be turned by hand without using a tool. The decoration screws 6 are screwed into the member supporting metal piercing through the bottom plate section 5a upward. The sockets 4 are projected to below the bottom plate section 5a through the socket through-holes.

The lighting fixture 1 is not limited to the lighting fixture for one lamp. The lighting fixture 1 can also be implemented as a lighting fixture for two lamps capable of supporting two lamps 11 explained below.

The lamp 11 detachably supported by the sockets 4 is explained below with reference to Figs. 2 to 12.

The lamp 11 has dimensions and an outer diameter same as those of an existing fluorescent lamp. The lamp 11 includes a pipe 12, the caps 13 attached to ends of the pipe 12, a beam 14, and at least one, for example, four light-emitting modules 15. Note that, when the four light-emitting modules 15 are distinguished, the light-emitting modules 15 are illustrated and explained with suffixes a to d added thereto.

The pipe 12 is formed, for example, straight by a translucent resin material. As the resin material forming the pipe 12, polycarbonate resin mixed with a diffusing material can be suitably used. The diffusion transmittance of the pipe 12 is 90% to 95%. As shown in Fig. 2, the pipe 12 has a pair of convex sections 12a on the inner surface in a part, which is an upper part in a state of use of the pipe 12.

The type of the caps 13 is G13. The caps 13 are respectively attached to the longitudinal direction both ends of the pipe 12. The caps 13 are detachably connected to the sockets 4. The lamp 11 supported by the sockets 4 by the connection is arranged right below the bottom plate section 5a of the reflecting member 5. A part of light emitted from the lamp 11 to the outside is made incident on the side plate section 5b of the reflecting member 5.

The respective caps 13 include terminal pins 13a and 13b as representatively shown in Fig. 2. The terminal pins 13a and 13b are projected to the outside of the caps 13. The terminal pins 13a and 13b are electrically insulated from each other. The terminal pins 13a and 13b of the caps 13 are connected to the sockets 4, whereby the lamp 11 is supported by the sockets 4. In this supported state, electric power can be supplied to the lamp 11 by the power supply terminal in the socket 4 on one side and the terminal pins 13a and 13b set in contact with the power supply terminal.

As shown in Fig. 2, the beam 14 is housed in the pipe 12. The beam 14 is a bar material excellent in mechanical strength and formed of, for example, an aluminum alloy to reduce weight. Longitudinal direction both ends of the beam 14 is coupled to the caps 13 while being electrically insulated therefrom. The beam 14 includes a plurality of substrate supporting sections 14a (only one is shown in Fig. 2) formed in, for example, a rib shape.

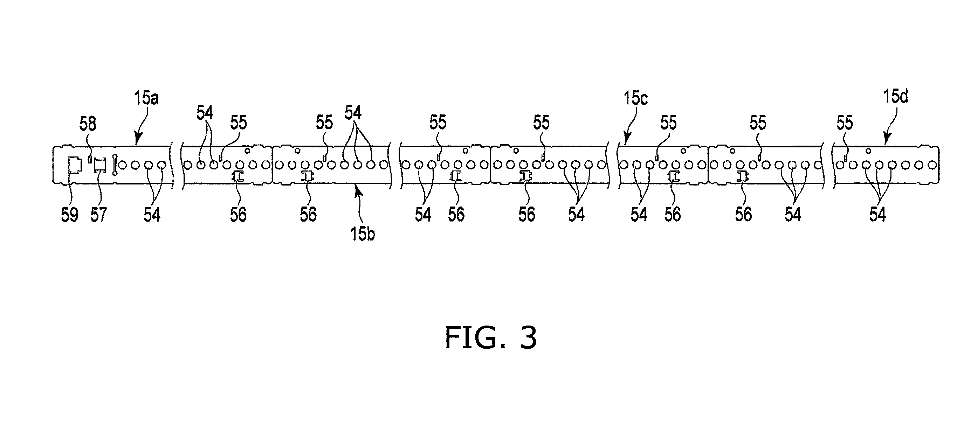

As shown in Fig. 3, all the four light-emitting modules 15a to 15d are formed in an elongated rectangular shape and arranged to form a straight row. The length of the row is substantially equal to the total length of the beam 14. The light-emitting modules 15a to 15d are fixed by not-shown screws screwed into the beam 14 through the light-emitting modules 15a to 15d.

Therefore, the light-emitting modules 15a to 15d are housed in the pipe 12 together with the beam 14. In this supported state, width direction both ends of the light-emitting modules 15a to 15d are placed on the convex sections 12a of the pipe 12. Consequently, the light-emitting modules 15a to 15d are disposed substantially in parallel further on the upper side than a largest width section in the pipe 12.

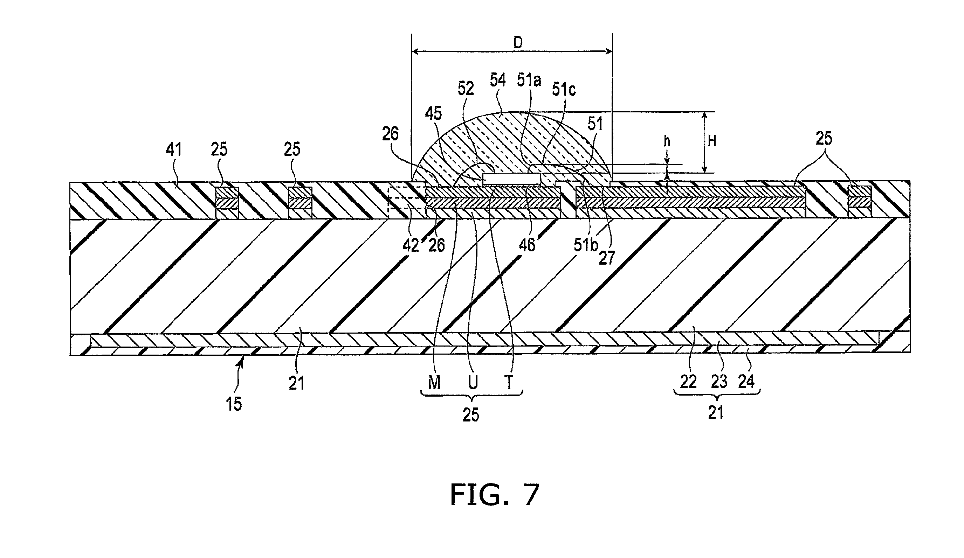

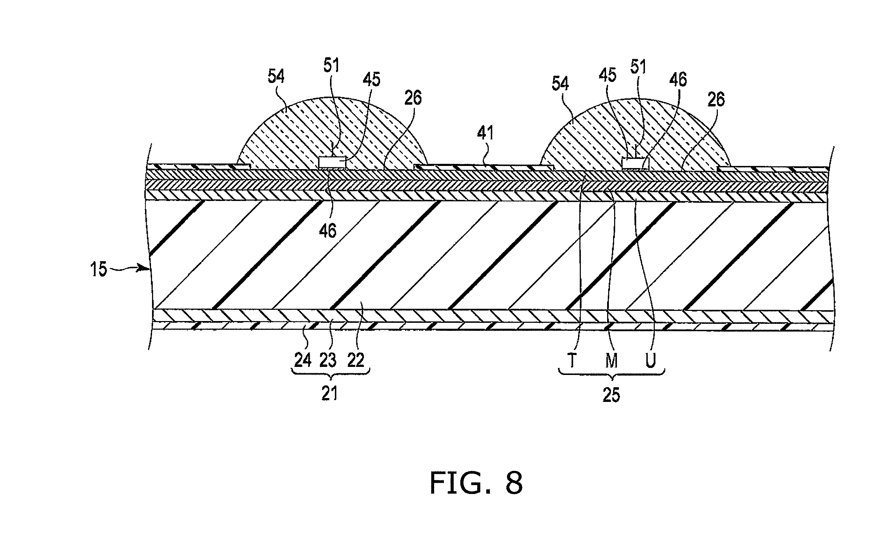

As shown in Figs. 7 and 8, each of the light-emitting modules 15 includes a substrate 21, a wiring pattern 25, a protection member 41, a plurality of light-emitting elements 45, a first wire 51, a second wire 52, a sealing member 54, and various electric components 55 to 59.

The substrate 21 includes a base 22, a metal foil 23, and a cover layer 24.

The base 22 is made of resin, for example, glass epoxy resin. A substrate (FR-4) made of the glass epoxy resin is low in thermal conductivity and relatively inexpensive. The base 22 may be formed by a glass composite substrate (CEM-3) or other synthetic resin materials.

As shown in Figs. 7 and 8, the metal foil 23 is laminated on the rear surface of the substrate 21 and formed by, for example, a copper foil. The cover layer 24 is laminated over a peripheral portion rear surface of the metal foil 23 and the base 22. The cover layer 24 is formed by a resist layer made of an insulating material, for example, synthetic resin. The substrate 21 is reinforced by the metal foil 23 and the cover layer 24, which are laminated on the rear surface of the substrate 21, not to warp.

As shown in Figs. 7 and 8, the wiring pattern 25 is formed on the front surface of the base 22 (i.e., the front surface of the substrate 21) in a three-layer structure. A first layer U is formed of copper plated on the front surface of the base 22. A second layer M is plated on the first layer U and formed of nickel. A third layer T is plated on the second layer M and formed of silver.

Therefore, the surface of the wiring pattern 25 is made of silver. The third layer T made of silver forms a reflection surface. The total light reflectance of the third layer T is equal to or higher than 90%.

For example, white resist layer containing electrically insulative synthetic resin as a main component can be suitably used for the protection member 41. The white resist layer functions as a reflection layer having high light reflectance. The protection member 41 is formed on the substrate 21 to cover the most part of the wiring pattern 25. That is, the protection member 41 covers the wiring pattern 25 while leaving a plurality of parts of the wiring pattern 25 as mounting pads 26. At the same time, the protection member 41 covers the wiring pattern 25 while leaving a plurality of parts of the wiring pattern 25 as wire connecting sections 27. Further, the protection member 41 covers the wiring pattern 25 while leaving mounting parts of the below-mentioned electric components 55 to 59.

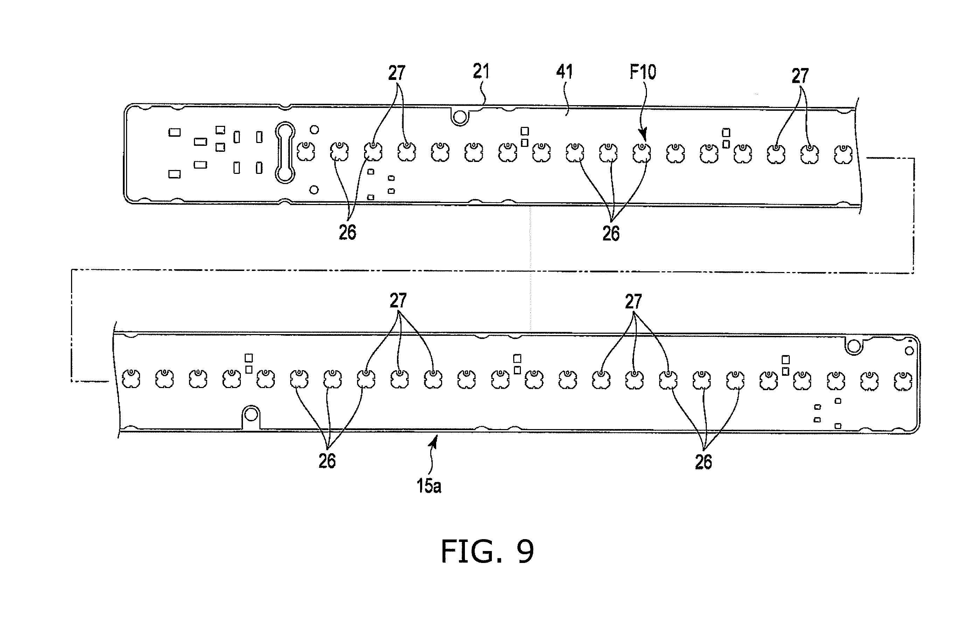

At a stage when the protection member 41 is formed on the substrate 21, the mounting pads 26 and the wire connecting sections 27 are formed in portions where the third layer T is exposed without being covered with the protection member 41. As shown in Fig. 9, the mounting pads 26 are arranged in the longitudinal direction of the substrate 21. The wire connecting sections 27 are respectively disposed in the vicinities of the mounting pads 26 while forming pairs with the mounting pads 26. Therefore, the wire connecting sections 27 are arranged in the longitudinal direction of the substrate 21 at a disposing pitch same as a disposing pitch of the mounting pads 26.

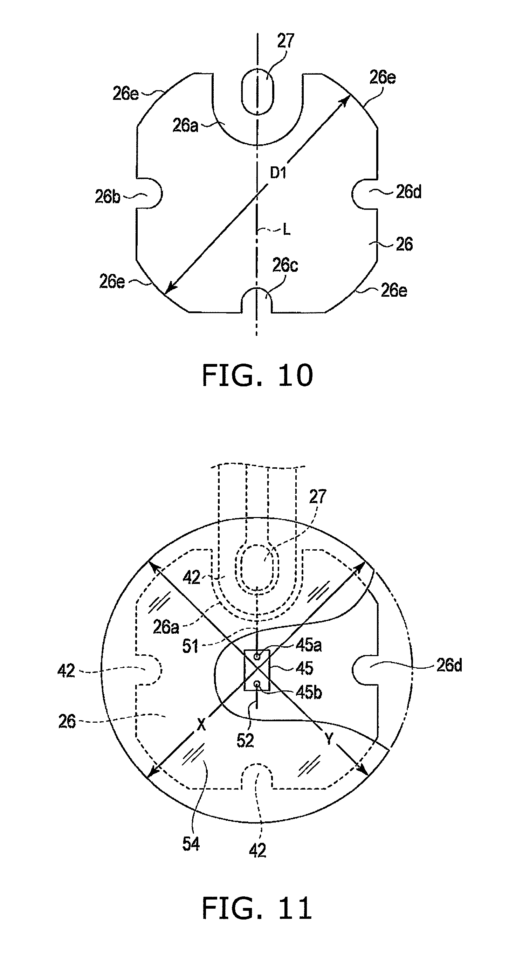

As shown in Figs. 10 and 11, the mounting pad 26 has grooves 26a to 26d in at least one part, for example, four parts in the peripheral portion of the mounting pad 26. The grooves 26a to 26b are separated from one another by 90 degrees. The depths of the grooves 26a to 26b are 1/10 to 1/5 of a below-mentioned pad diameter D1. Further, the peripheral edge of the mounting pad 26 has arcuate edge portions 26e at every 90 degrees. The edge portions 26e are formed between the grooves adjacent to each other in the peripheral direction of the mounting pad 26 among the grooves 26a to 26d.

Since the mounting pad 26 has the grooves 26a to 26b and the edge portions 26e, the mounting pad 26 is formed in a substantial clover shape. The groove 26a is larger than the other three grooves 26b to 26d. The wire connecting section 27 is disposed on the inside of the groove 26a. The mounting pad 26 is formed symmetrically with respect to a straight line L (indicated by an alternate long and short dash line in Fig. 10) that passes the center of the mounting pad 26 and the wire connecting section 27.

In this way, the mounting pad 26 is formed in the substantial clover shape and the wire connecting section 27 is provided in the groove 26a. This can contribute to a reduction in a diameter D of the below-mentioned sealing member 54. A pad diameter D1 of the mounting pad 26 is, for example, 3.6 mm. The pad diameter D1 is a dimension between the edge portions 26e located to form a pair across the center of the mounting pad 26.

The protection member 41 is filled in the grooves 26a to 26b. Portions of the protection member 41 filled in the grooves 26a to 26b are referred to filled parts 42 (see Figs. 7 and 11). The filled parts 42 form convex portions projected toward the center of the mounting pad 26. The filled parts 42 are projected from the surface of the third layer T with respect to the laminating direction of the wiring pattern 25 (see Fig. 7). When the below-mentioned light-emitting element 45 is mounted on the mounting pad 26, at least one of the filled parts 42 is used as a reference for deducing a mounting position of the light-emitting element 45. The filled parts 42 are filled in the groove 26a avoiding the wire connecting section 27.

The protection member 41 is filled in the grooves 26a to 26b. The portions of the protection member 41 filled in the grooves 26a to 26b are referred to filled parts 42 (see Figs. 7 and 11). The filled parts 42 are projected from the surface of the third layer T with respect to the laminating direction of the wiring pattern 25 (see Fig. 7). The filled parts 42 are filled in the groove 26a avoiding the wire connecting section 27.

The plurality of light-emitting elements 45 are formed by bare chips of LEDs. As the bare chips, for example, bare chips of LEDs that emit blue light are used. The bare chip of the LED includes a light-emitting layer on one surface of an element substrate made of sapphire. A plane shape of the bare chip is rectangular. As shown in Fig. 11, an element electrode 45b forming an anode and an element electrode 45a forming a cathode are provided side by side, for example, in the longitudinal direction of the bare chip of the LED.

In the light-emitting elements 45, the other surface of the element substrate on the opposite side of the one surface is fixed to the mounting pads 26, which are the reflection surfaces, using an adhesive 46 (see Figs. 7 and 8). In this case, the light-emitting elements 45 are respectively bonded on the mounting pads 26 with the arrangement of the element electrodes 45a and 45b aligned with the arrangement of the grooves 26a and 26c of the mounting pad 26. The light-emitting elements 45 mounted on the mounting pads 26 form a light-emitting element row arranged in the longitudinal direction of the substrate 21 (a direction in which the center axis extends). In the row, a disposing pitch of the light-emitting elements 45 is equal to or larger than 5 mm and equal to or smaller than 9 mm.

A bonding part of the light-emitting element 45 is preferably the center of the mounting pad 26. Consequently, light emitted from the light-emitting element 45 and made incident on the mounting pad 26 can be reflected in a reflection surface region around the light-emitting element 45.

In this case, the light made incident on the mounting pad 26 is more intense in a part closer to the light-emitting element 45. The intense light can be reflected in the reflection surface region. The grooves 26a to 26d are out of the reflection surface region where the intense light is reflected. Therefore, the area of the surface (the reflection surface) of the mounting pad 26 is reduced by the grooves 26a to 26d in the peripheral portion of the mounting pad 26. However, this does not substantially reduce reflection performance of the mounting pad 26 and can be neglected.

Light emission of the light-emitting element 45 formed by the bare chip of the LED is realized by feeding a forward direction current to a p-n junction of a semiconductor. Therefore, the light-emitting element 45 is a solid-state element that directly converts electric energy into light. The light-emitting element 45 that emits light according to such a light emission principle has an energy saving effect compared with an incandescent lamp that causes a filament to glow at high temperature through energization and emits visible light through thermal radiation of the filament.

The adhesive 46 preferably has thermal resistance in obtaining durability of bonding and further has translucency in order to allow reflection even right under the light-emitting element 45. As such an adhesive 46, it is possible to suitably use a silicone resin-based adhesive.

The first wire 51 and the second wire 52 are made of a thin metallic wire, for example, a thin wire of gold and wired using a bonding machine.

As shown in Fig. 7, the first wire 51 is provided to electrically connect the light-emitting element 45 and the wiring pattern 25. In this case, one end 51a of the first wire 51 is connected to the element electrode 45a of the light-emitting element 45. The other end 51b of the first wire 51 is connected to the wire connecting section 27 of the wiring pattern 25.

The one end 51a of the first wire 51 is projected in a direction away from the light-emitting element 45 in the thickness direction of the light-emitting direction 45. The wire connecting section 27 is closer to the substrate 21 side than the element electrodes 45a and 45b of the light-emitting element 45 with respect to the thickness direction of the light-emitting element 45. The other end 51b of the first wire 51 is obliquely connected to the wire connecting section 27.

An intermediate portion 51c of the first wire 51 is a part occupying a portion between the one end 51a and the other end 51b. As shown in Fig. 7, the intermediate portion 51c is formed to be bent from the one end 51a to be parallel to the light-emitting element 45. Projection height h of the intermediate portion 51c with respect to the light-emitting element 45 is specified to be equal to or larger than 75µm and equal to or smaller than 125 µm, preferably, equal to or larger than 60 µm and equal to or smaller than 100 µm. Consequently, the wire-bonded first wire 51 is wired with the height based on the light-emitting element 45 retained low (this wiring structure is referred to as low wiring loop in this specification).

The intermediate portion 51c and the other end 51b of the first wire 51 wired in this way extend in a direction orthogonal to a direction in which the light-emitting elements 45 form a row. Such wiring is realized by the explained arrangement of the light-emitting element 45 with respect to the mounting pad 26. The length of the first wire 51 can be reduced by the wiring. Therefore, the costs of the first wire 51 can be reduced compared with the case in which the first wire 51 is arranged obliquely to the light-emitting element 45 in plan view.

The second wire 52 is provided to connect the light-emitting element 45 and the mounting pad 26 through wire bonding. In this case, one end of the second wire 52 is connected to the element electrode 45b of the light-emitting element 45 by first bonding. The other end of the second wire 52 is connected to the mounting pad 26 by second bonding.

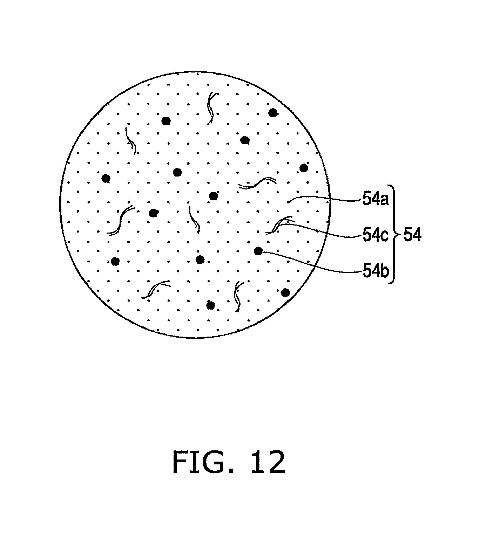

The sealing member 54 is formed by mixing appropriate amounts of a phosphor 54b and a filler 54c in resin 54a, which is a main component, as schematically shown in Fig. 12.

Resin-based silicone resin or hybrid silicone resin having translucency is used for the resin 54a. The resin-based silicone resin and the hybrid silicone resin are harder than translucent silicone rubber because the resin-based silicone resin and the hybrid silicone resin have a three-dimensionally crosslinked structure.

The phosphor 54b is excited by light emitted by the light-emitting element 45 and emits light having a color different from a color of light emitted by the light-emitting element 45. In the first embodiment, since the light-emitting element 45 emits blue light, a yellow phosphor that emits, through the excitation, yellowish light having a complementary color relation with the blue light is used. Consequently, it is possible to emit white light as output light of the lamp 11, which is the light-emitting device.

The sealing member 54 is formed on the substrate 21 to seal the mounting pad 26, the wire connecting section 27, the light-emitting element 45, the first wire 51, and the second wire 52 by burying the same. The sealing member 54 is formed by being dripped targeting the light-emitting element 45 in an unhardened state and thereafter subjected to heat treatment to be hardened. A dispenser or the like is used for the dripping (potting) of the sealing member 54.

The hardened sealing members 54 are arranged on the substrate 21 at a predetermined interval in the longitudinal direction of the substrate 21 and disposed to form a sealing member row according to the row of the light-emitting elements 45. The hardened sealing members 54 are bonded on the substrate 21. That is, in the case of this embodiment, the bottom surface of the sealing member 54 is bonded to the mounting pad 26 of the wiring pattern 25 formed on the substrate 21 and the protection member 41 around the mounting pad 26. The sealing members 54 are heaped up from the bottom surfaces thereof and are each formed to bury the light-emitting elements 45. The sealing members 54 are formed in a dome shape or a Fuji mountain shape.

The diameter D (see Fig. 7) of the sealing member 54 is specified to 1.0 to 1.4 times of the pad diameter D1. In the case of the first embodiment, the diameter D is 4.0 mm to 5.0 mm. Consequently, a part of the mounting pad 26 does not protrude from the sealing member 54. At the same time, the sealing member 54 is not excessive with respect to the mounting pad 26. It is possible to use a proper amount of the sealing member 54 while retaining a below-mentioned aspect ratio. Note that a frame or the like that surrounds the light-emitting element 45 and the like in order to specify the height H of the heap of the sealing member 54 from the bottom surface and the diameter D of the bottom surface is absent. Therefore, the diameter D and the height H of the sealing member 54 are controlled according to a dripping amount, hardness, and time until hardening of the sealing member 54.

The height H of the heap of the sealing member 54 based on the light-emitting element 45 is equal to or larger than 1.0 mm. The aspect ratio of the sealing member 54 is set to 0.22 to 1.00 in order to secure the height H equal to or larger than 1.0 mm. The aspect ratio of the sealing member 54 is a ratio of the diameter D of the bottom surface of the sealing member 54 to the height H of the heap of the sealing member 54 that buries the light-emitting element 45.

Further, a ratio of orthogonal diameters of the sealing member 54 is 0.55 to 1.00. The ratio of the orthogonal diameters indicates a ratio of diameters X and Y orthogonal to each other of the bottom surface of the sealing member 54 bonded to the substrate 21 as shown in Fig. 11. The diameter X is the diameter of the bottom surface arbitrarily drawn to pass through the center of the light-emitting element 45. The diameter Y is the diameter of the bottom surface drawn to be orthogonal to the diameter X.

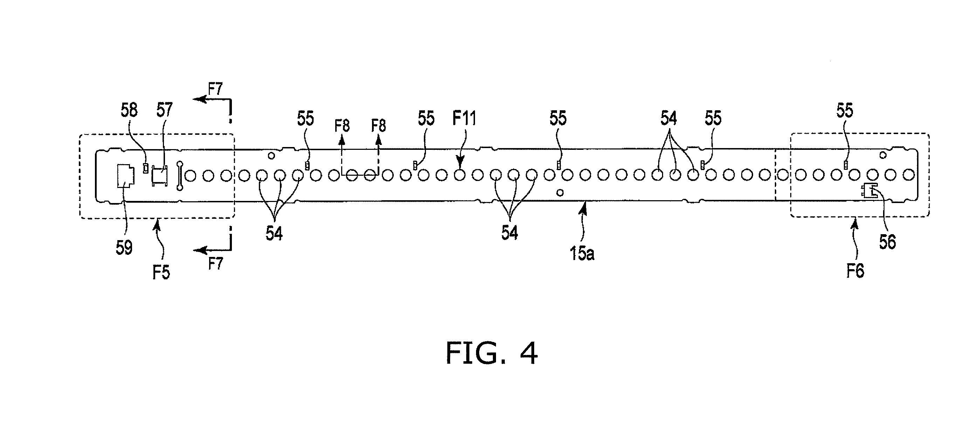

The electric component 55 shown in any one of Figs. 4 to 6 is a capacitor. The electric component 56 is a connector. The electric component 57 is a rectifying diode. The electric component 58 is a resistor. The electric component 59 is an input connector.

The electric component 55 consisting of the capacitor is mounted in each of the four light-emitting modules 15. The capacitor suppresses noise from being superimposed on the wiring patterns 25 of the light-emitting modules 15 to thereby prevent the light-emitting elements 45 to emit light by mistake.

As shown in Fig. 3, concerning the light-emitting modules 15a and 15d disposed at longitudinal direction both ends of a module row formed by the four light-emitting modules 15, the electric component 56 consisting of the connector is mounted at only one ends of the light-emitting modules 15a and 15d. Further, concerning the light-emitting modules 15b and 15c disposed between the light-emitting modules 15a and 15d, the electric component 56 is mounted at each of longitudinal direction both ends of the light-emitting modules 15a and 15d. The electric components 56 of the adjacent light-emitting modules 15 are connected by a not-shown electric wire extending across the electric components 56. Consequently, the light-emitting modules 15 are electrically connected in series.

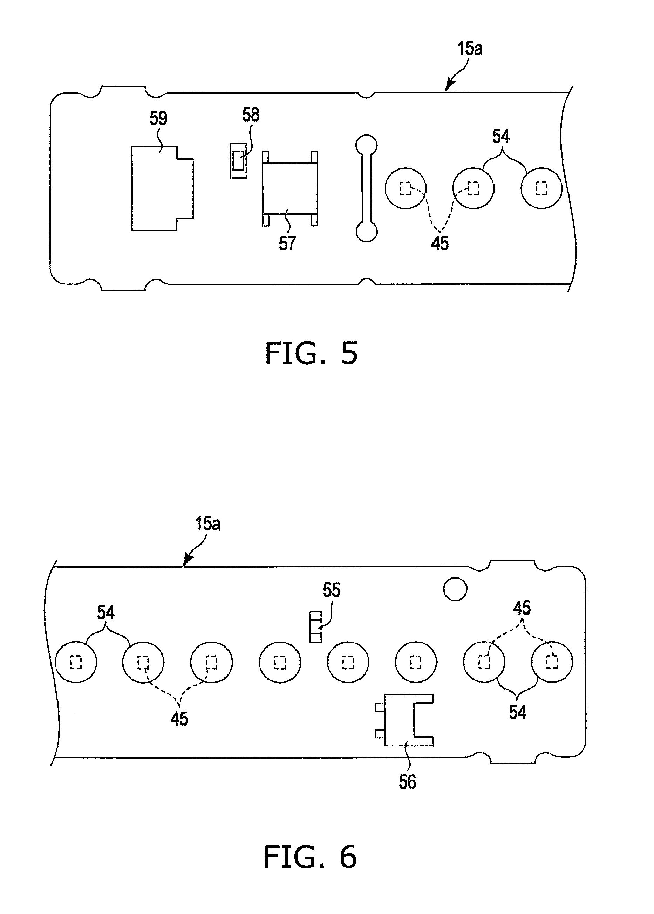

As shown in Fig. 5, all the electric components 57 to 59 are mounted at the other end of the light-emitting module 15a. The electric component 59 consisting of the input connector is connected to the wiring pattern 25 of the light-emitting module 15. The electric component 59 consisting of the input connector is connected to the wiring pattern 52 of the light-emitting module 15. The not-shown electric wire connected to the electric component 59 is connected to each of the terminal pins 13a and 13b of the cap 13 disposed closer to the electric component 59.

When the straight tube type lamp 11 having the above-mentioned configuration is supported by the sockets 4 of the lighting fixture 1 and electric power is supplied to the lamp 11, each of the light-emitting elements 45 emits light. According to the light emission, white light emitted from the sealing member 54 is diffused by the pipe 12 and transmitted through the pipe 12 to be emitted to the outside. Consequently, a space below the lamp 11 is illuminated. At the same time, a part of the white light emitted from the pipe 12 is reflected by the side plate section 5b of the reflecting member 5 and illuminates a space further on the upper side than the lamp 11.

The mounting pad 26 of the light-emitting module 15 included in the lamp 11 forming such a light source of illumination is formed in a part of the wiring pattern 25, the surface of which is made of silver. Consequently, the mounting pads 26 on which the light-emitting elements 45 are respectively mounted function as reflection surfaces of light.

At the same time, the sealing member 54 that buries the mounting pad 26, the light-emitting element 45, the wire connecting unit 27, the first wire 51, and the like and seals the same is formed of resin-based silicone resin. A crosslinked structure of the resin-based silicone resin is three-dimensional. Therefore, compared with silicone oil and silicone rubber, performance for transmitting gasses such as oxygen, water vapor, and the like is low. Incidentally, the oxygen permeability of the sealing member 54 is equal to or lower than 1200 cm³ (m²·day·atm) and the water vapor permeability of the sealing member 54 is equal to or lower than 35 g/m². The water vapor permeability is preferably equal to or lower than 20 g/m².

The mounting pad 26, the surface of which is the reflection layer of silver, is sealed by the resin-based silicone resin having the low gas permeability in this way. Consequently, deterioration in reflection performance due to discoloration of the mounting pad 26 caused by transmission of gas in the atmosphere through the sealing member 54 is suppressed. Therefore, it is possible to improve a luminous flux maintenance factor.

Incidentally, a luminous flux maintenance factor of the conventionally provided straight tube type LED lamp is about 70% in 40, 000 hours. Compared with this, it has been confirmed by a test of the inventor that the lamp 11 in the first embodiment can improve the luminous flux maintenance factor to 94% in 40,000 hours.

Incidentally, the sealing member 54 expands and contracts every time lighting and extinguishing of the lamp 11 are repeated. According to the expansion and contraction, stress is applied to the first wire 51 buried by the sealing member 54. On the other hand, the resin-based silicone resin has high hardness compared with silicone rubber. If the hardness of the sealing member 54 is high, the stress applied to the first wire 51 increases as the projection height h of the first wire 51 with respect to the light-emitting element 45 is higher.

However, the first wire 51 is wired to form the low wiring loop. That is, the intermediate portion 51c of the first wire 51 is formed to be bent from the one end 51a of the first wire 51 connected to the light-emitting element 45 to be parallel to the light-emitting element 45. At the same time, the projection height h of the intermediate portion 51c with respect to the light-emitting element 45 is equal to or larger than 75 µm and equal to or smaller than 125 µm. In this way, the first wire 51 extending over the light-emitting element 45 and the wire connecting unit 27 is wired with the height thereof specified low.

Consequently, it is possible to reduce the stress applied to the first wire 51 according to the expansion and contraction of the sealing member 54. Therefore, the first wire 51 is suppressed from being cut in a connecting section of the one end 51a of the first wire 51 and the light-emitting element 45 according to a heat cycle based on the lighting and extinguishing of the lamp 11.

As explained above, with the lamp 11 in the first embodiment, it is possible to improve the luminous flux maintenance factor while suppressing disconnection of the first wire 51 connected to the light-emitting element 45.

Further, the phosphor 54b is mixed in the sealing member 54 included in the lamp 11 in the first embodiment. At the same time, the aspect ratio (H/D) representing a relation between the height H of the heap of the sealing member 54 based on the light-emitting element 45 and the diameter D of the bottom surface of the sealing member 54 is specified to 0.22 to 1.00. According to such specification of the aspect ratio, it is possible to secure a distance equal to or larger than 1 mm as the distance from the light-emitting element 45 to the positions on the surface of the sealing member 54.

Consequently, an angular color difference is suppressed and it is possible to suppress color unevenness of parts such as the pipe 12 irradiated by light emitted from the sealing member 54 and the side plate section 5b of the reflecting member 5 irradiated by the light transmitted through the pipe 12. In other words, it is possible to suppress a region irradiated in a bluish color by intense light of the light-emitting element 45 and a region irradiated in a yellowish color by intense light emitted from the phosphor 54b from being mixed to be conspicuous.

Moreover, in the first embodiment, the hardness after formation of the sealing member 54 is specified to be equal to or higher than 54 and equal to or lower than 94 in Shore hardness. Consequently, it is possible to suppress the angular color difference.

That is, since the sealing member 54 contains the filler 54c, the hardness of the sealing member 54 increases and thixotropy in the unhardened state of the sealing member 54 provided by potting is improved. Therefore, the potted sealing member is suppressed from spreading before being thereafter heated and hardened and decreasing in height H.

Therefore, the predetermined aspect ratio (H/D) is secured. It is possible to secure a distance equal to or larger than 1 mm as the distance from the light-emitting element 45 to the positions on the surface of the sealing member 54.

Note that, on the other hand, if the filler 54c is not mixed, the thixotropy is deteriorated. According to the deterioration in the thixotropy, the sealing member 54 easily spreads before being hardened and the height of the sealing member 54 decreases. Therefore, it is difficult to secure a distance equal to or larger than 1 mm as the distance from the light-emitting element 45 to the positions on the surface of the sealing member 54. If the content of the filler 54c is too high, fluidity of the unhardened sealing member is lower than a specified value. Therefore, an appropriate amount of the potting is difficult and it is more likely that a potting failure is caused.

Further, the grooves 26a to 26d are formed in the peripheral portion of the mounting pad 26 included in the lamp 11 in the first embodiment. The filled parts 42 of the protection member 41 filled in the grooves 26a to 26d are covered with the sealing member 54 and bonded to the sealing member 54. At the same time, the peripheral portion of the sealing member 54 is bonded to the protection member 41.

In the first embodiment, adhesiveness of the sealing member 54 made of silicone resin and the surface made of silver of the mounting pad 26 covered with the sealing member 54 is inferior to adhesiveness of resins. Therefore, if the diameter D of the sealing member 54 is reduced, it is more likely that the sealing member 54 peels off the substrate 21.

However, as explained above, the filled parts 42 of the protection member 41 made of resin in the grooves 26a to 26d of the mounting pad 26 are bonded to the mounting pad 26 made of resin. Consequently, holding performance of the sealing member 54, which seals the mounting pad 26 and the like, to the substrate 21 is improved.

Therefore, even if the mounting pad 26 is reduced in diameter, peeling of the mounting pad 26 is suppressed. Therefore, it is possible to reduce an amount of use of the sealing member 54. At the same time, the sealing member 54 is suitable for, for example, increasing disposing density of the mounting pads 26 and the light-emitting elements 45.

Further, in the first embodiment, the pipe 12 made of resin having the diffusive translucency, in which the light-emitting module 15 is housed, diffuses light emitted from the light-emitting module 15 and emits the light to the outside as illumination light. Moreover, the pipe 12 is straight and the caps 13 are respectively attached to the longitudinal direction both ends of the pipe 12. Therefore, the lamp 11 in the first embodiment can be implemented as a straight tube type lamp, which is a light source.

Moreover, the translucency of the pipe 12 is equal to or lower than 85% and the disposing pitch of the light-emitting elements 45 is equal to or larger than 5 mm and equal to or smaller than 9 mm.

If the translucency of the pipe 12 exceeds 85% and light permeability increases, the plurality of light-emitting elements 45 arranged in the longitudinal direction of the substrate 21 further tend to change to light dots to be reflected on the pipe 12. If the disposing pitch of the light-emitting elements 45 is smaller than 5 mm, according to the disposing pitch, the light-emitting elements 45 are arranged at high density along the longitudinal direction of the substrate 21. Therefore, the light-emitting elements 45 are a main cause of an increase in costs. Conversely, if the disposing pitch of the light-emitting elements 45 exceeds 9 mm, the light-emitting elements 45 are arranged at low density. Therefore, the light-emitting elements 45 further tend to be reflected on the pipe 12.

Therefore, in the first embodiment in which the diffusive translucency of the pipe 12 and the disposing pitch of the light-emitting elements 45 are specified as explained above, it is possible to suppress, at low costs, the plurality of light-emitting elements 45 from changing to light spots to be reflected on the pipe 12. At the same time, it is possible to flash the pipe 12 at substantially uniform brightness.

The first embodiment is configured as explained above. However, embodiments of the present invention are not limited to the first embodiment. For example, in the first embodiment, the light-emitting device is explained as the lamp including the caps. However, the light-emitting device can be implemented as a light-emitting device not including caps.

## Claims

1. A light-emitting device comprising a light-emitting module,
the light-emitting module including:
a substrate;
a plurality of light-emitting elements made of semiconductor disposed on the substrate; and
a plurality of sealing members containing, as a main component, translucent resin mixed with a phosphor, heaped up from bottom surfaces thereof bonded on the substrate, and each formed to bury a singularity or a plurality of the light-emitting elements, a ratio (H/D) of a diameter D of the bottom surfaces to height H of the heaps of the sealing members being set to 0.22 to 1.0.

2. The device according to claim 1, wherein the sealing member is resin-based silicone resin and hardness of the sealing member after formation is equal to or higher than 54 and equal to or lower than 94 in Shore hardness.

3. The device according to claim 1, wherein a wiring pattern is formed on the substrate, the light-emitting element is mounted on a mounting pad formed by a part of the wiring pattern, a wire connecting section adjacent to the mounting pad is formed on the substrate, the light-emitting device includes a wire that connects the mounting pad and the wire connecting section, one end of the wire connected to the light-emitting element is projected in a thickness direction of the light-emitting element to separate from the element, the other end of the wire connected to the wire connecting section is oblique, an intermediate portion of the wire between the one end and the other end is formed to be bent from the one end to be parallel to the light-emitting element, and projection height of the intermediate portion with respect to the light-emitting element is equal to or larger than 75 µm and equal to or smaller than 125 µm.

4. The device according to claim 3, wherein a protection member made of resin covering the wiring pattern is formed on the substrate, the mounting pad is covered with the sealing member, a groove is formed in at least one part of a peripheral portion of the mounting pad, and a filled part of the protection member filled in the groove is bonded to the sealing member.

5. The device according to claim 1, further comprising a diffusive translucent pipe in which the light-emitting module is housed.

6. The device according to claim 5, wherein translucency of the pipe is equal to or lower than 85% and a disposing pitch of the light-emitting elements is equal to or larger than 5 mm and equal to or smaller than 9 mm.

7. A luminaire comprising:
a luminaire main body;
at least a pair of sockets attached to the luminaire main body; and
a straight tube type light-emitting device including a diffusive translucent straight pipe, a light-emitting module formed long in an extending direction of the pipe and housed in the pipe, and caps attached to longitudinal direction both ends of the pipe, the light-emitting device being supported detachably to the sockets, wherein
the light-emitting module including:
a substrate;
a plurality of light-emitting elements made of semiconductor disposed on the substrate; and
a plurality of sealing members containing, as a main component, translucent resin mixed with a phosphor, heaped up from bottom surfaces thereof bonded on the substrate, and each formed to bury a singularity or a plurality of the light-emitting elements, a ratio (H/D) of a diameter D of the bottom surfaces to height H of the heaps being set to 0.22 to 1.0.
